# EUROPEAN PATENT APPLICATION

(11) **EP 4 585 934 A1**
(43) Date of publication of application: **16.07.2025**
(21) Application number: 23862935.6
(22) Date of filing: 23.08.2023
(51) Int. Cl.: G01R 29/08, H01L 21/28, H01L 29/423, H01L 29/49, H01L 29/786

(54) **SENSOR DEVICE CAPABLE OF MEASURING ELECTRIC FIELD INTENSITY AND METHOD FOR MEASURING ELECTRIC FIELD INTENSITY**

(30) Priority: 05.09.2022 JP 2022140939
(71) Applicant: Otowa Electric Co. Ltd., Kita-ku Osaka-shi Osaka 531-0072 (JP)
(72) Inventor: KNAREEKUNNAN, Afsal, Nomi-shi, Ishikawa 923-1292 (JP); MIZUTA, Hiroshi, Nomi-shi, Ishikawa 923-1292 (JP); MURUGANATHAN, Manoharan, Nomi-shi, Ishikawa 923-1292 (JP); KUDO, Takeshi, Amagasaki-shi, Hyogo 661-0976 (JP); MARUYAMA, Takeshi, Amagasaki-shi, Hyogo 661-0976 (JP)
(74) Representative: Patentanwälte Ruff, Wilhelm, Beier, Dauster & Partner mbB
(86) International application number: PCT/JP2023/030296
(87) International publication number: WO 2024/053396

(57) **Abstract**

Provided is a sensor device with high measurement sensitivity for an external electric field. The sensor device is able to measure electric field strength of an external electric field.

The sensor device has a first dielectric layer, a channel layer disposed directly on the first dielectric layer and having a channel region, and also having an atomic layer material film of one or more atomic layers formed by a two-dimensional transition metal dichalcogenide, and a first electrode and second electrode disposed on either side of the channel region, in electrical contact with the channel layer, wherein the channel layer has a first side and a second side, the first side being disposed on the first dielectric layer, and the second side being exposed to the outside or a second dielectric layer being disposed on the second side, and the Fermi level of the channel layer being positioned in the conduction band or valence band of the channel layer, and located above the trap level band at the interface of the first dielectric layer with the channel layer.

## Description

### FIELD

The present invention relates to a sensor device for measuring electric field strength and to a method for measuring electric field strength.

### BACKGROUND

Sensor devices have conventionally been used for measurement of electric field strength in air. Measurement of electric field strength in air allows monitoring of the development and movement of thunderclouds (see PTL 1, for example).

Sensor devices are also used to measure electric field strength in indoor atmospheres. Such measurement of electric field strength allows monitoring of the condition of indoor static electricity to help prevent accidents caused by static electricity.

Sensor devices that measure electric field strength include mechanical sensor devices (see PTL 1, for example). However, mechanical sensor devices have relatively large dimensions and heavy weights.

Semiconductor sensor devices have therefore been proposed (see NPL 1, for example). Semiconductor sensor devices have relatively smaller dimensions and lighter weights.

Semiconductor sensor devices employ transistors that may include graphene as a channel layer. The electric field strength of an external electric field applied to the semiconductor sensor device is measured as the size of the current flowing between the source electrode and drain electrode.

### CITATION LIST

### PATENT LITERATURE

[PTL 1] Japanese Unexamined Patent Publication No. 2020-46213

### NON PATENT LITERATURE

[NPL 1] WANG et al., High-performance graphene-based electrostatic field sensor, IEEE ELECTRON DEVICE LETTERS, VOL 38, No.8, AUGUST 2017

### SUMMARY OF INVENTION

### TECHNICAL PROBLEM

The measurement sensitivity for measuring the external electric field of a semiconductor sensor device is affected by the mobility of carriers in the channel layer and the Fermi level state density. The measurement sensitivity is higher with greater carrier mobility. The measurement sensitivity is also higher with higher Fermi level state density.

However, while high carrier mobility is exhibited by graphene, its Fermi level state density is low. It is therefore expected that increasing the Fermi level state density in the channel layer will further improve the measurement sensitivity of a semiconductor sensor device.

The present disclosure proposes a sensor device with high measurement sensitivity for measurement of an external electric field, by using a channel layer with high Fermi level state density.

### SOLUTION TO PROBLEM

(1) One aspect of the disclosure provides a sensor device. The sensor device is a sensor device capable of measuring electric field strength of an external electric field, including a first dielectric layer, a channel layer disposed directly on the first dielectric layer and having a channel region, and also having an atomic layer material film of one or more atomic layers formed by a two-dimensional transition metal dichalcogenide, and a first electrode and second electrode disposed on either side of the channel region, in electrical contact with the channel layer, wherein the channel layer has a first side and a second side, the first side being disposed on the first dielectric layer, and the second side being exposed to the outside or a second dielectric layer being disposed on the second side, and the Fermi level of the channel layer being positioned in the conduction band or valence band of the channel layer and located above the trap level band at the interface of the first dielectric layer with the channel layer.

(2) The sensor device of (1) preferably has the second dielectric layer, and has a gate electrode disposed on the second dielectric layer and having an atomic layer material film of one or more atomic layers.

(3) Another aspect of the disclosure provides a method of measuring an external electric field using the sensor device of the embodiment (1). The method of measuring an external electric field includes measuring a current value flowing between the first electrode and second electrode while the external electric field is applied to the sensor device, and determining the electric field strength of the external electric field based on the current value.

(4) Yet another aspect of the disclosure provides a method of measuring an external electric field using the sensor device of the embodiment (2). The method of measuring an external electric field includes measuring a current value flowing between the first electrode and second electrode while varying the gate voltage applied to the gate electrode, to determine the first gate voltage representing the maximum or minimum current value, and measuring a current value flowing between the first electrode and second electrode when an external electric field is applied to the sensor device, while a second gate voltage determined based on the first gate voltage is being applied to the gate electrode, and determining the electric field strength of the external electric field based on the current value.

### ADVANTAGEOUS EFFECTS OF INVENTION

The sensor device of the disclosure has high measurement sensitivity for measurement of an external electric field, by using a channel layer with high Fermi level state density.

The method for measurement of an external electric field of the disclosure allows measurement of an external electric field with high sensitivity because it uses a sensor device having a channel layer with high Fermi level state density.

### BRIEF DESCRIPTION OF DRAWINGS

Fig. 1(A) is a cross-sectional view of a first embodiment of the sensor device disclosed herein, and (B) is a plan view of the same.
Fig. 2 is a diagram illustrating the relationship between electron energy and state density in a channel layer.
Fig. 3(A) shows the relationship between energy levels when the channel layer and dielectric layer are separated, (B) shows the relationship between energy levels when the channel layer and dielectric layer are in contact, and (C) shows the relationship between energy levels when a voltage is being applied to the gate electrode.
Fig. 4 is a diagram showing a state where an external electric field is applied to a sensor device in the negative direction.
Fig. 5 is a diagram showing the relationship between sensor device sensitivity and electric field strength of an external electric field.
Fig. 6 is a diagram showing a modified example of a sensor device according to the first embodiment.
Fig. 7(A) is a cross-sectional view of a second embodiment of the sensor device disclosed herein, and (B) is a plan view of the same.
Fig. 8 is a flow chart for measurement of an external electric field using the sensor device of the second embodiment.
Fig. 9 is a graph illustrating a method for measuring an external electric field using the sensor device of the second embodiment.
Fig. 10 (A) and (B) are diagrams illustrating the production steps for one embodiment of the method for producing the sensor device disclosed herein (1).
Fig. 11 (A) and (B) are diagrams illustrating the production steps for one embodiment of the method for producing the sensor device disclosed herein (2).
Fig. 12 (A) and (B) are diagrams illustrating the production steps for one embodiment of the method for producing the sensor device disclosed herein (3).

### DESCRIPTION OF EMBODIMENTS

A first preferred embodiment of the sensor device disclosed herein will now be described with reference to the accompanying drawings. The technical scope of the invention is not limited to this embodiment, however, and includes the invention and its equivalents as laid out in the Claims.

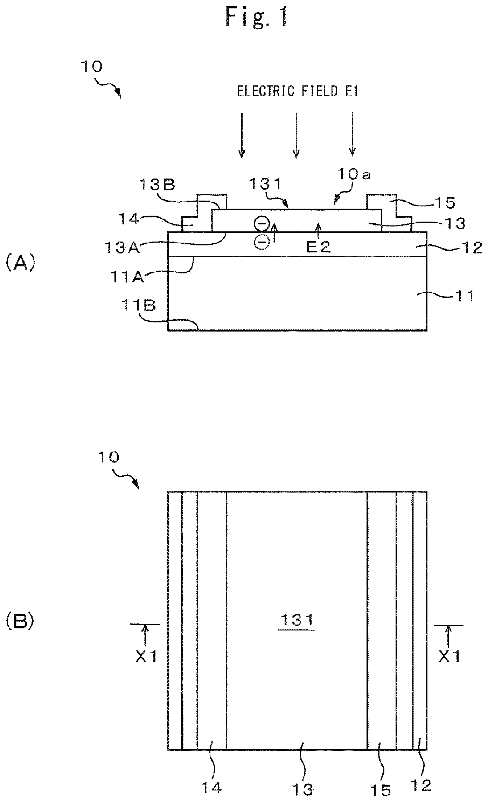

Fig. 1(A) shows a first embodiment of the sensor device disclosed herein, being a cross-sectional view of Fig. 1(B) along X1-X1, and Fig. 1(B) is a plan view of the same. Fig. 1(A) shows a state where an external electric field is applied to a sensor device from the outside in the positive direction.

The sensor device 10 of the embodiment allows measurement of the electric field strength of an external electric field E1 applied from the outside. The external electric field E1 is an electric field produced from a generation source located outside of the sensor device 10. The sensor device 10 has high sensitivity and therefore allows measurement of a small electric field strength.

The sensor device 10 has a substrate 11, a dielectric layer 12, a channel layer 13, a source electrode 14 and a drain electrode 15. The sensor device 10 of the embodiment is able to measure the size of an external electric field E1 as current, since the sensor device 10 acts as a transistor when an external electric field is applied. As will be explained in detail below, the sensor device 10 has high sensitivity because the channel layer 13 has an atomic layer material film of one or more atomic layers formed by a two-dimensional transition metal dichalcogenide. The sensor device 10 is thereby able to measure even a small external electric field E1.

The substrate 11 has enough mechanical strength to support the other constituent elements of the sensor device 10. The substrate 11 has a first side 11A and a second side 11B. The substrate 11 may be a semiconductor substrate such as a silicon, silicon carbide or compound semiconductor substrate. A semiconductor substrate used as a substrate may be amorphous, polycrystalline or single crystal. The substrate 11 may have either p-type polarity or n-type polarity. The substrate may also be intrinsic without addition of impurities. If the dielectric layer 12 has enough mechanical strength to support the other constituent elements of the sensor device 10 then the sensor device 10 does not need to have a substrate 11.

The dielectric layer 12 has electrical insulating properties and is disposed on the first side 11A of the substrate 11. The dielectric layer 12 electrically insulates the substrate 11 and the channel layer 13.

The dielectric layer 12 used may be a dielectric material such as silicon dioxide (SiO₂), aluminum oxide, hafnium dioxide or silicon nitride. When the substrate 11 is a silicon substrate, using silicon dioxide as the dielectric layer 12 is preferred for production of the sensor device 10.

Trap levels that can trap carriers may be present at the interface of the dielectric layer 12 with the channel layer 13, due to defects or impurities. When the dielectric layer 12 is SiO₂, for example, a trap level band composed of multiple trap levels forms near the center of the band gap of the dielectric layer 12. From the viewpoint of increasing the number of trap levels, the surface of the dielectric layer 12 is preferably irradiated with oxygen ions, nitrogen ions or helium ions.

The channel layer 13 has a channel region 131 and is disposed directly on the dielectric layer 12. The channel layer 13 has a first side 13A and a second side 13B. The first side 13A is disposed on the dielectric layer 12, and the second side 13B is exposed to the outside. The second side 13B functions as an input/output region 10a in which the sensor device 10 inputs or outputs an external electric field E1.

That the channel layer 13 is disposed directly on the dielectric layer 12 means that substantially no other layers are disposed between the channel layer 13 and dielectric layer 12. However, this allows for the presence of layers such as an oxide layer incidentally formed on the surface of the channel layer 13 or the surface of the dielectric layer 12.

The channel region 131 is preferably disposed on at least the dielectric layer 12. For this embodiment, the entire channel layer 13 is disposed on the dielectric layer 12. The channel layer 13 may have either p-type polarity or n-type polarity.

The channel layer 13 has an atomic layer material film of one or more atomic layers, formed by a two-dimensional transition metal dichalcogenide.

The channel layer 13 preferably includes molybdenum (Mo), tungsten (W) or niobium (Nb) as a transition metal. The channel layer 13 preferably also includes sulfur (S), selenium (Se) or tellurium (Te) as a chalcogenide element. Examples of two-dimensional transition metal dichalcogenides include MoS₂, MoSe₂, WS₂, WSe₂, NbS₂ and NbSe₂.

The source electrode 14 and drain electrode 15 are disposed in electrical contact with the channel layer 13, oppositely sandwiching the channel region 131 of the channel layer 13. For this embodiment, part of the source electrode 14 and drain electrode 15 are disposed on the channel layer 13. The source electrode 14 and drain electrode 15 have electrical conductivity. When measuring an external electric field E1 using the sensor device 10, a predetermined voltage is applied between the source electrode 14 and the drain electrode 15.

The sensor device 10 acts as a transistor. By application of the external electric field E1 to the channel layer 13, the sensor device 10 has variable drain current flowing between the source electrode 14 and drain electrode 15.

The sensitivity of the sensor device 10 acting as the transistor depends on the mobility of carriers in the channel layer 13 and the state density of carriers near the Fermi level of the channel layer 13. A greater carrier mobility corresponds to higher sensitivity of the sensor device 10. A higher state density of carriers near the Fermi level also corresponds to higher sensitivity of the sensor device 10.

The sensor device 10 of the embodiment has high sensitivity due to the high state density of carriers near the Fermi level in the channel layer 13.

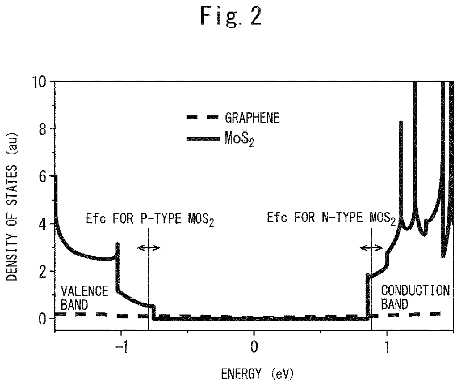

Fig. 2 is a calculation result graph showing the relationship between electron energy and density of states (DOS), for MoS₂ as the channel layer 13. The abscissa in Fig. 2 represents electron energy of the channel layer 13, and the ordinate represents electron density of states. The density of states of the electrons represents the number of states of electrons per unit energy per unit volume. The electron density of states is shown as a relative value in Fig. 2.

In the channel layer 13, as shown in Fig. 2, the density of states in the conduction band and valence band is high and the density of states in the band gap is low. When the channel layer 13 has n-type polarity, the Fermi level Efc is located in the conduction band of the channel layer 13 (near the lower end). When the channel layer 13 has p-type polarity, the Fermi level Efc is located in the valence band of the channel layer 13 (near the top end).

Fig. 2 shows the relationship between energy and density of states of electrons of MoS₂, as a two-dimensional transition metal dichalcogenide, and graphene, formed by the same atomic layer material film. The density of states of MoS2 electrons is about 16 times the density of states of electrons of graphene near the lower end of the conduction band. The density of states of MoS₂ electrons is therefore much higher than graphene. For the other two-dimensional transition metal dichalcogenide as well, the density of states of electrons of MoS₂ is likewise higher than graphene. Two-dimensional transition metal dichalcogenide having n-type or p-type polarity has a band gap, whereas graphene does not have a band gap.

The channel layer 13 preferably has an atomic layer material film formed of one or more atomic layers, from the viewpoint of improving the sensitivity of the sensor device 10. From the viewpoint of higher sensitivity of the sensor device 10, the channel layer 13 preferably has an atomic layer material film formed of 1 to 4, and especially two atomic layers. When the number of atomic layers forming the atomic layer material film increases, the density of states of electrons near the Fermi level of the channel layer 13 decreases (see K.C. Wang et. al., Journal of Applied Physics, 122, 224302, (2017), for example), and therefore the sensitivity of the sensor device 10 for the external electric field E1 decreases.

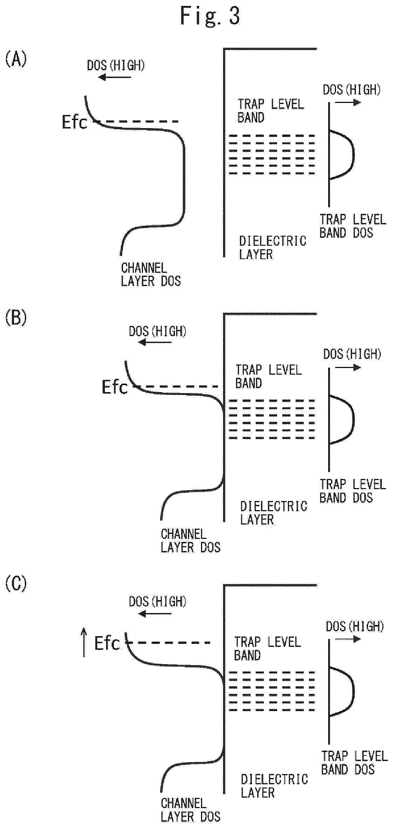

Fig. 3(A) is a diagram showing the relationship between energy levels when the channel layer 13 and dielectric layer 12 are separated. The illustration at left in Fig. 3(A) represents distribution of density of states (DOS) of electrons of the channel layer 13. The illustration at right in Fig. 3(A) represents the distribution of density of states (DOS) of the trap level band and trap level band of the dielectric layer 12. This also applies for Fig. 3(B) and Fig. 3(C). When the channel layer 13 has n-type polarity, the Fermi level Efc is located at the lower end of the conduction band of the channel layer 13.

The interface of the dielectric layer 12 with the channel layer 13 has a trap level band that includes multiple trap levels. The trap level band is located near the center of the band gap of the dielectric layer 12.

Fig. 3(B) is a diagram showing the relationship between energy levels when the channel layer 13 and dielectric layer 12 are in contact. Fig. 3(B) represents the state of the sensor device 10 shown in Fig. 1(A). Fig. 3(B) shows the state before the electrons of the channel layer 13 move to the trap level band of the dielectric layer 12. The Fermi level Efc is located at the lower end of the conduction band of the channel layer 13, as before contact.

The Fermi level Efc of the channel layer 13 is located slightly above the trap level band at the interface of the dielectric layer 12 with the channel layer 13. Application of an external electric field E1 to the sensor device 10 allows electrons to move between the energy level at or below the Fermi level Efc of the channel layer 13, and the trap level band of the channel layer 13.

In the sensor device 10, the density of states of electrons is high near the Fermi level Efc of the channel layer 13 (see Fig. 2). Specifically, since the number of electrons is large in the conduction band at or below the Fermi level Efc of the channel layer 13, a large number of electrons are able to move between the channel layer 13 and the trap level band of the dielectric layer 12.

The explanation using Fig. 3(B) was for a case where the channel layer 13 is an n-type two-dimensional transition metal dichalcogenide, but this explanation also applies as appropriate for a case where the channel layer 13 is a p-type two-dimensional transition metal dichalcogenide.

When the channel layer is formed by graphene, on the other hand, the density of states of the electrons in the Fermi level Efc of the channel layer is low (see Fig. 2). Specifically, since the number of electrons is small in the conduction band at or below the Fermi level Efc of the channel layer 13, the number of electrons able to move between the channel layer 13 and the trap level band of the channel layer 13 is small.

The following explanation concerns measurement of electric field strength as change in drain current when an external electric field E1 has been applied to the sensor device 10.

In Fig. 1(A), an external electric field E1 is applied to the sensor device 10 in the positive direction, from the outside toward the sensor device 10. The electric lines of force of the positive external electric field E1 run in the direction from the channel layer 13 toward the substrate 11. The electric lines of force of the external electric field E1 enter the sensor device 10 from the input/output region 10a, and exit outward through the second side 11B of the substrate 11.

The external electric field E1 that has passed through the input/output region 10a of the sensor device 10 causes electrons in the trap level band at the interface of the dielectric layer 12 to move to the conduction band of the channel layer 13.

The number of electrons moving to the conduction band of the channel layer 13 depends on the size of the external electric field E1. The number of electrons moving to the conduction band of the channel layer 13 also depends on the density of states of electrons near the Fermi level Efc. The number of electrons moving to the conduction band of the channel layer 13 depends on the area of the input/output region 10a.

The electrons that have moved to the conduction band of the channel layer 13 generate an internal electric field E2 inside the sensor device 10. Action of the internal electric field E2 on the channel layer 13 alters the Fermi level Efc of the channel layer 13. When the Fermi level of the channel layer 13 is altered, the size of the drain current flowing to the channel region 131 between the source electrode 14 and drain electrode 15 changes.

When the channel layer 13 is an n-type channel, increasing Fermi level Efc causes increase in the drain current, while decreasing Fermi level Efc causes reduction in drain current. When the channel layer 13 is a p-type channel, the relationship between the Fermi level and drain current is the reverse.

The sensor device 10 can measure the size of the external electric field E1 based on the degree of change in the drain current value with respect to the drain current value without application of the external electric field E1 to the sensor device 10.

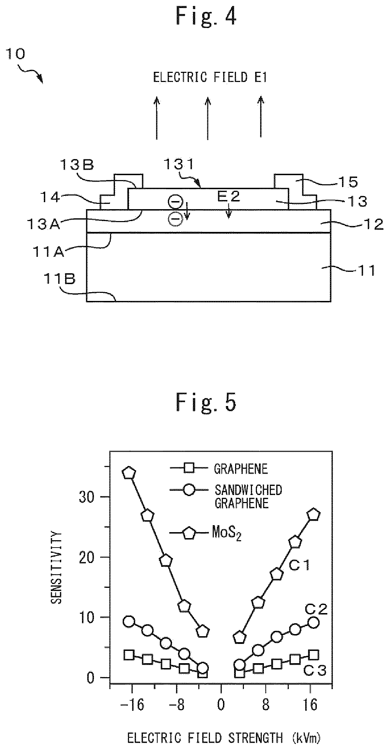

Fig. 4 is a diagram showing a state where an external electric field E1 is applied to a sensor device 10 in the negative direction. The electric lines of force of the negative external electric field E1 run in the direction from the substrate 11 to the channel layer 13. The electric lines of force of the external electric field E1 enter the sensor device 10 from the second side 11B of the substrate 11 and exit outward through the input/output region 10a.

The external electric field E1 that has passed through the second side 11B of the substrate 11 of the sensor device 10 causes electrons in the conduction band near the Fermi level of the conduction band of the channel layer 13 to move to the trap level band at the interface of the dielectric layer 12. The difference between the energy level of the conduction band and the energy level in the trap level band disappears due to inelastic scattering, such as lattice vibration.

The electrons that have moved to the trap level band at the interface of the dielectric layer 12 generate an internal electric field E2 inside the sensor device 10. Action of the internal electric field E2 on the channel layer 13 alters the Fermi level of the channel layer 13. When the Fermi level of the channel layer 13 is altered, the size of the drain current flowing to the channel region 131 between the source electrode 14 and drain electrode 15 changes.

The sensor device 10 can measure the size of the external electric field E1 based on the degree of change in the drain current value with respect to the drain current value without application of the external electric field E1 to the sensor device 10.

Fig. 5 is a diagram showing the relationship between sensor device 10 sensitivity and electric field strength of an external electric field. The relationship shown in Fig. 5 was obtained by using parallel plates disposed on either side of the sensor device 10 with a spacing of 3 cm, and varying the voltage applied between the parallel plates. The sensitivity of the sensor device 10 represents the rate of change in the drain current value with respect to the drain current value without application of the external electric field E1 to the sensor device 10.

The measurement results C1 show the relationship between the sensitivity of the sensor device 10 with a MoS₂ channel layer 13, and electric field strength of the external electric field. When a positive external electric field has been applied to the sensor device 10, the sensitivity increases as the size of the external electric field increases. When a negative external electric field has been applied to the sensor device 10, the sensitivity increases as the size of the absolute value of the external electric field increases.

Fig. 5 shows measurement results C2 for a reference sensor device having a channel layer of graphene sandwiched above and below with hexagonal boron nitride, and measurement results C3 for a reference sensor device having a channel layer of graphene. Both measurement results C2 and C3 show the same relationship as C1.

C1 shows much greater sensitivity than C2 or C3. For example, when the electric field strength is 16 kV/m, the C1 sensitivity is about 7 times the C3 sensitivity.

The sensitivity of the sensor device 10 depends on the density of states of the carriers and on the mobility of the carriers. The mobility of electrons in graphene is about 2000 cm² V⁻¹s⁻¹. The mobility of electrons in MoS2 is 1 to 10 cm² V⁻¹s⁻¹. Even though the mobility of electrons in MoS2 is 1/2000 to 1/200 that of graphene, the sensitivity is about 7 times higher.

The reason that the sensor device 10 of the embodiment exhibits high sensitivity is thought to be that the density of states near the Fermi level of the channel layer 13 is much higher than graphene.

The measurement sensitivity for measurement of an external electric field is high due to the use of a channel layer with high Fermi level state density.

The sensor device 10 further provides the following advantages compared to mechanical sensor devices of the prior art. A mechanical sensor device, having dimensions of several tens of cm and a weight of several kg, is restricted in terms of where it can be installed. However, the dimensions of the present sensor device 10 are at most several cm, with a maximum weight of a few grams, even when modularized to provide suitable measuring function, and therefore the sensor device 10 has much more moderate restrictions on possible installation locations. Moreover a mechanical sensor device, which has a driving unit, is prone to malfunction and requires maintenance. In this regard the sensor device 10, being a semiconductor sensor, has a greatly reduced chance of malfunction. A mechanical sensor device also has high power consumption and requires a power supply device such as an AC power source. The sensor device 10, on the other hand, has low power consumption and can therefore run on a simple power supply device such as a battery.

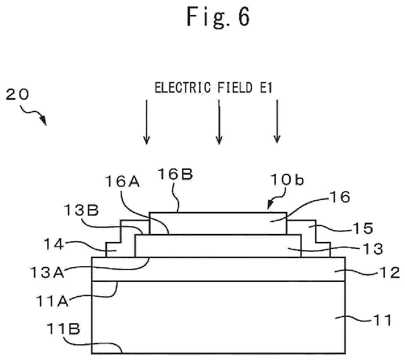

Fig. 6 is a diagram showing a modified example of a sensor device 20 according to the first embodiment. A second dielectric layer 16 is disposed on the second side 13B of the channel layer 13 of the sensor device 20 of this modified example. The second dielectric layer 16 has an electrical insulating property and functions to protect the channel layer 13.

The second dielectric layer 16 has a first side 16A and a second side 16B. The first side 16A is disposed on the channel layer 13, and the second side 16B is exposed to the outside. The second side 16B functions as an input/output region 10b in which the sensor device 10 inputs or outputs an external electric field E1. The electric lines of force of the external electric field E1 enter the sensor device 10 from the input/output region 10b, and exit outward through the second side 11B of the substrate 11.

From the viewpoint of protecting the channel layer 13, the second dielectric layer 16 used is preferably a dielectric material such as silicon dioxide, aluminum oxide or silicon nitride.

By using a material with high permittivity as the second dielectric layer 16 it is possible to amplify an external electric field to act on the channel layer 13. Examples of materials that can amplify external electric fields include silicon dioxide, silicon nitride, zirconium dioxide and hafnium dioxide.

With the sensor device of the modified example as described above it is possible to increase the measuring sensitivity for an external electric field by amplification of the external electric field via the second dielectric layer 16. The sensor device of this embodiment can also exhibit the same effects as the first embodiment.

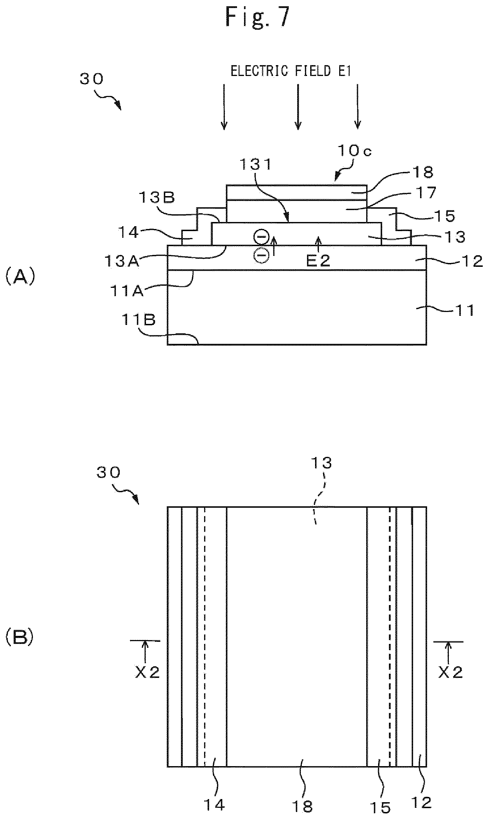

A second embodiment of the sensor device will now be described with reference to Fig. 7(A) and Fig. 7(B). The detailed explanation provided for the first embodiment applies for any aspects of the second embodiment that are not explained here. The same reference numerals are also used for corresponding constituent elements.

Fig. 7(A) shows a second embodiment of the sensor device disclosed herein, being a cross-sectional view of Fig. 7(B) along line X2-X2, and Fig. 7(B) is a plan view of the same. Fig. 7(A) shows a state where an external electric field is applied to a sensor device from the outside.

The sensor device 30 of this embodiment differs from the first embodiment described above in that it comprises a second dielectric layer 17 disposed on the channel layer 13, and a gate electrode 18 disposed on the second dielectric layer 17 and having an atomic layer material film of one or more atomic layers. The sensor device 30 has the same construction as the first embodiment, except for having the second dielectric layer 17 and gate electrode 18.

Application of a gate voltage to the gate electrode 18 in the sensor device 30 can alter the Fermi level Efc of the channel layer 13. The distribution of the density of states of carriers also shifts with movement of the Fermi level Efc. For this embodiment it is assumed that the size of the gate voltage is such that the shape of distribution of the density of states of carriers does not vary.

Fig. 3(C) is a diagram showing the relationship between energy levels when voltage is applied to the gate electrode 18. Application of voltage to the gate electrode 18 causes the position of the Fermi level Efc of the channel layer 13 to increase compared to the first embodiment. This increases the number of electrons in the conduction band at or below the Fermi level Efc of the channel layer 13. Fig. 3(C) shows the state before the electrons of the channel layer 13 move to the trap level band of the dielectric 12.

In the sensor device 30 of this embodiment, therefore, more of the carriers can move between the channel layer 13 and the trap level band of the dielectric layer 12, compared to the first embodiment. This increases the sensitivity of the sensor device 30.

The second dielectric layer 17 preferably has a small thickness and excellent electrical insulating properties. If the second dielectric layer 17 has a small thickness, then an external electric field E1 and gate voltage can be applied to the channel layer 13. If the second dielectric layer 17 has excellent electrical insulating properties, then it is possible to prevent flow of current between the gate electrode 18 and channel layer 13 when a gate voltage has been applied to the gate electrode 18.

The second dielectric layer 17 preferably has an atomic layer material film of one or more atomic layers, from the viewpoint of transmitting the external electric field E1 and applying the gate voltage to the channel layer 13. Specifically, the second dielectric layer 17 preferably has an atomic layer material film with 1 to 30 atomic layers.

The second dielectric layer 17 preferably essentially prevents flow of tunnel current between the gate electrode 18 and channel layer 13 when a gate voltage has been applied to the gate electrode 18. That the second dielectric layer 17 essentially prevents flow of tunnel current between the gate electrode 18 and channel layer 13 means that when a gate voltage has been applied to the gate electrode 18, the tunnel current flowing between the gate electrode 18 and channel layer 13 is 100pA or lower.

From the same viewpoint, the second dielectric layer 17 preferably has an atomic layer material film with one or more atomic layers formed of hexagonal boron nitride, molybdenum disulfide or tungsten disulfide. The second dielectric layer 17 may also be formed using an oxide such as SiO₂, but from the viewpoint of obtaining a high electrical insulating property it is preferably formed using an atomic layer material film.

The gate electrode 18 has electrical conductivity, and also transmits the external electric field E1. From this viewpoint, the gate electrode 18 is preferably formed of an atomic layer material film having one or more atomic layers. For example, the gate electrode 18 preferably has an atomic layer material film with 1 to 5 atomic layers. Specifically, the gate electrode 18 preferably has an atomic layer material film of 1 to 5 atomic layers formed of graphene.

The side of the gate electrode 18 that is exposed to the outside acts as an input/output region 10c where the sensor device 10 inputs or outputs the external electric field E1. The electric lines of force of the external electric field E1 enter the sensor device 10 from the input/output region 10c, and exit outward through the second side 11B of the substrate 11.

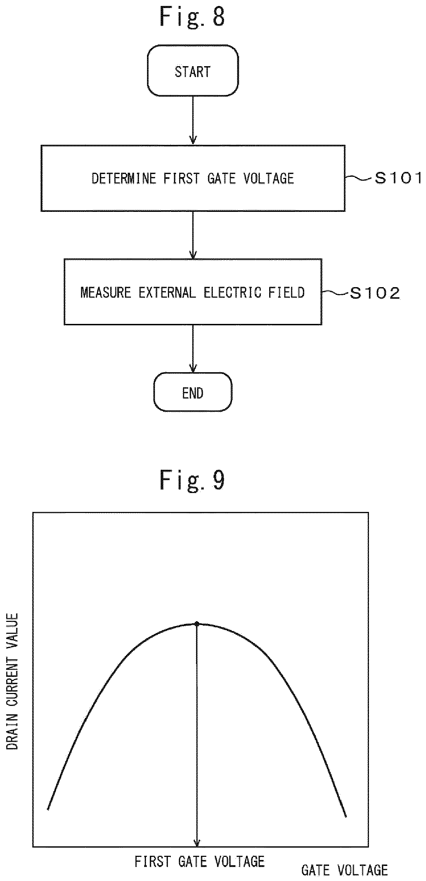

Fig. 8 is a flow chart for measurement of an external electric field using the sensor device of the second embodiment. A method for measuring an external electric field E1 using the sensor device 30 will now be explained with reference to Fig. 8.

First, the drain current value flowing between the source electrode 14 and drain electrode 15 is measured while varying the gate voltage applied to the gate electrode 18, and the first gate voltage representing the maximum or minimum of the drain current value is obtained (step S101 in Fig. 8). Depending on the orientation of the external electric field E1 and the polarity of the channel layer 13, the drain current value may represent either the maximum or the minimum.

When an external electric field is not being applied to the sensor device 10, the first gate voltage where the drain current value represents either the maximum or minimum may be obtained. The phrase "no external electric field is being applied to the sensor device 10" includes cases where an unintended external electric field may be being applied to the sensor device 10.

Likewise when the predetermined external electric field is being applied to the sensor device 10, the first gate voltage where the drain current value represents either the maximum or minimum may be obtained. For example, when external electric fields of different sizes are being applied, multiple gate voltages where the drain current value represents either the maximum or minimum may be calculated. The first gate voltage used may be the average of the multiple gate voltages.

Fig. 9 is a graph illustrating a method for measuring an external electric field using the sensor device of the second embodiment. The abscissa represents gate voltage, and the ordinate represents drain current value. When the gate voltage is varied, the drain current value represents the maximum. The gate voltage at which this maximum drain current value is represented is the first gate voltage.

The measuring gate voltage is determined based on the first gate voltage. For example, the measuring gate voltage used may be the first gate voltage. The measuring gate voltage used may also be a voltage with a magnitude of 70% to 100% of the first gate voltage. The measuring gate voltage is an example of the second gate voltage.

By measuring the drain current value flowing between the source electrode 14 and drain electrode 15 when the external electric field to be measured has been applied to the sensor device 10, while the measuring gate voltage is applied to the gate electrode 18, it is possible to obtaine the electric field strength of the external electric field based on the drain current value (step S102 of Fig. 8). By measuring the external electric field input or output through the input/output region 10c while the measuring gate voltage is applied, it is possible to calculate the electric field strength of the external electric field E1 in the state of highest sensitivity.

For example, when the measuring gate voltage has been applied to the gate electrode 18, the drain current value flowing between the source electrode 16 and drain electrode 17 is measured with application of external electric fields with multiple different electric field strengths. The relationship between drain current value and external electric field strength (current-electric field strength relationship) is thus ascertained.

The current-electric field strength relationship is used as reference to determine the electric field strength corresponding to the drain current value, in order to obtain the electric field strength of the external electric field E1.

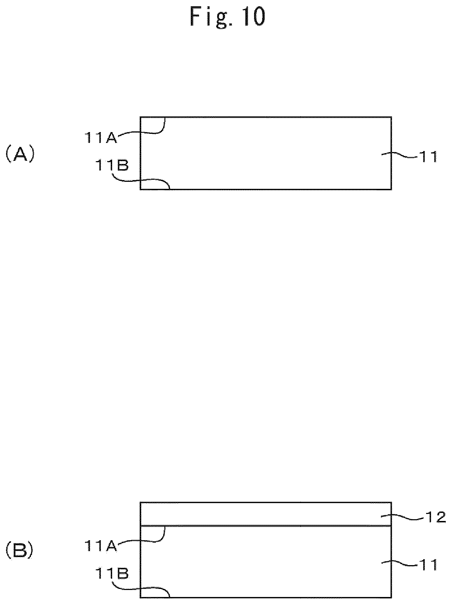

Preferred embodiments of the method for producing the sensor device of the first embodiment and second embodiment will now be described with reference to Fig. 10 to Fig. 12.

A substrate 11 with a first side 11A and a second side 11B is first prepared, as shown in Fig. 10(A). The substrate 11 may be a semiconductor substrate such as a silicon, silicon carbide or compound semiconductor substrate.

Next, as shown in Fig. 10(B), a dielectric layer 12 is formed on the first side 11A of the substrate 11. When a silicon substrate is used as the substrate 11, a silicon dioxide layer is preferably formed as the dielectric layer 12. The silicon dioxide layer is formed using a thermal oxidation or CVD method. When a silicon dioxide layer is formed as the dielectric layer 12 using thermal oxidation, the interface between the silicon dioxide layer and silicon constitutes the first side 11A. From the viewpoint of increasing the number of trap levels, the surface of the dielectric layer 12 may be irradiated with oxygen ions, nitrogen ions or helium ions.

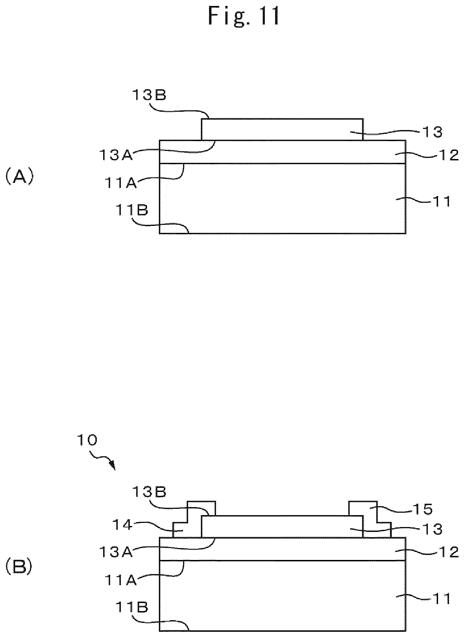

A channel layer 13 is then formed on the dielectric layer 12, as shown in Fig. 11(A). The channel layer 13 has a first side 13A and a second side 13B. The first side 13A is disposed on the dielectric layer 12, and the second side 13B is exposed to the outside.

The channel layer 13 has an atomic layer material film of one or more atomic layers, formed by a two-dimensional transition metal dichalcogenide. The channel layer 13 can be formed by an exfoliation method or CVD method, for example. The channel layer 13 most preferably is formed by the exfoliation method from the viewpoint of obtaining a high-quality atomic layer material film with few defects.

The thickness of the channel layer 13 is preferably in the range of 1 to 20, and more preferably 1 to 4 atomic layers. The thickness and quality of the channel layer 13 is measured using Raman spectroscopy, for example.

The channel layer 13 can be formed using molybdenum (Mo), tungsten (W) or niobium (Nb) as a transition metal, and sulfur (S), selenium (Se) or tellurium (Te) as a chalcogenide element. Examples of two-dimensional transition metal dichalcogenides to be used include MoS₂, MoSe₂, WS₂, WSe₂, NbS₂ and NbSe₂.

A source electrode 14 and drain electrode 15 are then formed on the channel layer 13 as shown in Fig. 11(B), to obtain a sensor device 10 of the first embodiment. The source electrode 14 and drain electrode 15 can be formed as a laminated body of chromium and gold.

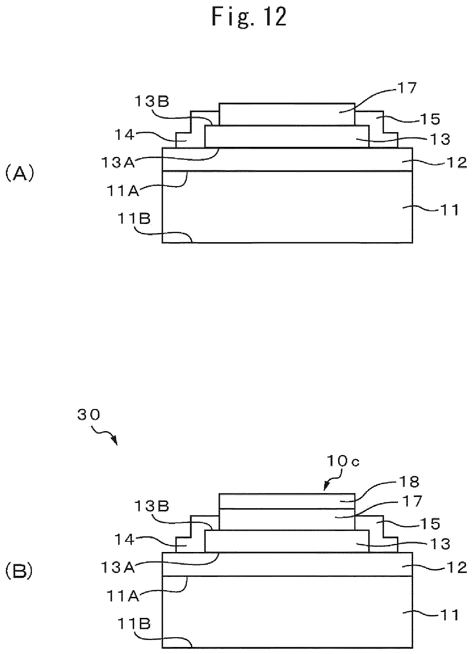

A second dielectric layer 17 is then formed on the second side 13B of the channel layer 13, as shown in Fig. 12(A). The second dielectric layer 17 is formed as an atomic layer material film having one or more atomic layers using a material with an electrical insulating property, for example. The second dielectric layer 17 can be formed by an exfoliation method or CVD method, for example. The second dielectric layer 17 most preferably is formed by an exfoliation method from the viewpoint of obtaining a high-quality atomic layer material film with few defects. Specifically, the second dielectric layer 17 is formed as an atomic layer material film with one or more atomic layers formed of hexagonal boron nitride, molybdenum disulfide or tungsten disulfide.

As shown in Fig. 12(B), the gate electrode 18 is formed on the second dielectric layer 17 to obtain a sensor device 30 of the second embodiment. The gate electrode 18 may be formed as a laminated body of chromium and gold, for example. The gate electrode 18 is formed as an atomic layer material film having one or more atomic layers using a material with electrical conductivity, for example. The gate electrode 18 can be formed by an exfoliation method or CVD method, for example. The gate electrode 18 most preferably is formed by an exfoliation method from the viewpoint of obtaining a high-quality atomic layer material film with few defects. Specifically, the gate electrode 18 is preferably formed as an atomic layer material film having one or more atomic layers formed of graphene.

The sensor device for measuring electric field strength and the method for measuring an external electric field according to the embodiments described above may be appropriately modified within the scope of the gist of the invention. The constituent features of any of the embodiments may also be applied as appropriate to the other embodiments.

### REFERENCE SIGNS LIST

10 Sensor device
10a, 10b, 10c Input/output region
11 Substrate
11A First side
11B Second side
12 Dielectric layer (first dielectric layer)
13 Channel layer
13A First side
13B Second side
131 Channel region
14 Source electrode (first electrode)
15 Drain electrode (second electrode)
16 Second dielectric layer
17 Second dielectric layer
18 Gate electrode

## Claims

1. A sensor device capable of measuring electric field strength of an external electric field, comprising:
a first dielectric layer;
a channel layer disposed directly on the first dielectric layer and having a channel region, and also having an atomic layer material film of one or more atomic layers formed by a two-dimensional transition metal dichalcogenide; and
a first electrode and second electrode disposed on either side of the channel region, in electrical contact with the channel layer; and wherein
the channel layer has a first side and a second side, the first side being disposed on the first dielectric layer, and the second side being exposed to the outside or a second dielectric layer being disposed on the second side, and
the Fermi level of the channel layer being positioned in the conduction band or valence band of the channel layer, and the Fermi level of the channel layer being located above the trap level band at the interface of the first dielectric layer with the channel layer.

2. The sensor device according to claim 1, wherein the channel layer has an atomic layer material film formed of one or more atomic layers.

3. The sensor device according to claim 1, wherein the channel layer comprises molybdenum, tungsten or niobium as a transition metal, and sulfur, selenium or tellurium as a chalcogenide element.

4. The sensor device according to claim 1,
having the second dielectric layer disposed on the second side of the channel layer, and
comprising a gate electrode with an atomic layer material film of one or more atomic layers.

5. The sensor device according to claim 4, wherein the second dielectric layer has an atomic layer material film of one or more atomic layers.

6. The sensor device according to claim 4, wherein the second dielectric layer essentially does not allow flow of tunnel current between the gate electrode and the channel layer.

7. The sensor device according to claim 4, wherein the second dielectric layer has an atomic layer material film with one or more atomic layers formed of hexagonal boron nitride, molybdenum disulfide or tungsten disulfide.

8. The sensor device according to claim 4, wherein the gate electrode has an atomic layer material film with one or more atomic layers formed of graphene.

9. A method for measuring an external electric field using the sensor device according to claim 1, the method comprising:
measuring a current value flowing between the first electrode and second electrode while the external electric field is being applied to the sensor device; and
determining the electric field strength of the external electric field based on the current value.

10. A method of measuring an external electric field using a sensor device according to claim 4, the method comprising:
measuring a current value flowing between the first electrode and second electrode while varying a gate voltage applied to the gate electrode, to determine the first gate voltage representing the maximum or minimum current value; and
measuring a current value flowing between the first electrode and second electrode when an external electric field is applied to the sensor device, while a second gate voltage determined based on the first gate voltage is being applied to the gate electrode, and determining the electric field strength of the external electric field based on the current value.
